# FASCICULE DE BREVET EUROPEEN

(11) **EP 1 627 432 B1**
(45) Date de publication et mention de la délivrance du brevet: **25.03.2009**
(21) Numéro de dépôt: 04728819.6
(22) Date de dépôt: 22.04.2004
(51) Int. Cl.: H01L 27/146

(54) **CAPTEUR D IMAGE MATRICIEL EN TECHNOLOGIE CMOS**
CMOS BILDAUFNAHMEVORRICHTUNG
MATRIX IMAGE RECORDER USING CMOS TECHNOLOGY

(30) Priorité: 23.05.2003 FR 0306202
(43) Date de publication de la demande: 22.02.2006
(73) Titulaire: E2V Semiconductors, 38120 Saint Egreve (FR)
(72) Inventeur: BRISSOT, Louis, Thales Intellectual Property, F-94117 Arcueil (FR)
(74) Mandataire: Guérin, Michel
(86) Numéro de dépôt international: PCT/EP2004/050587
(87) Numéro de publication internationale: WO 2004/105136

(56) Documents cités:
- EP-A- 0 492 597
- EP-A- 0 718 889
- EP-A- 1 187 217
- EP-A- 1 195 986
- EP-A- 1 223 623
- EP-A- 1 310 999
- US-A- 2001 015 831
- US-B1- 6 566 697

## Description

L'invention concerne les capteurs d'image matriciels destinés notamment à la photographie numérique.

Une technologie classique utilise des capteurs de technologie CCD (technologie à transfert de charges) mais il est apparu qu'on pouvait aussi utiliser une technologie dite CMOS qui a l'avantage de permettre de réaliser sur une même puce de circuit intégré en silicium à la fois le capteur d'image proprement dit, c'est-à-dire une matrice de points photosensibles, et des circuits électroniques de traitement d'image complexes. Cette technologie CMOS a par ailleurs l'intérêt de consommer moins d'énergie. Mais elle a l'inconvénient de ne pas permettre une séparation facile de l'acquisition d'une image et de la lecture de cette image.

Typiquement, on voudrait pouvoir acquérir globalement toute l'image pendant une durée d'exposition qui non seulement est la même pour tous les points d'image (ou pixels) mais qui commence au même instant pour tous les points et se termine au même instant, avant qu'on ne passe à une opération de lecture des charges électroniques engendrées en chaque point par cette exposition.

Ceci n'est possible que si on dispose au niveau de chaque pixel d'un stockage des charges accumulées en ce point, d'un moyen pour limiter la durée d'exposition, c'est-à-dire la durée d'acquisition de charges pour tous les pixels de la matrice, et d'un moyen pour transférer ensuite point par point les charges stockées dans le pixel vers des sorties de la matrice. Ces éléments étaient disponibles en technologie CCD et comprenaient des zones de stockage en nombre égal aux zones de photodétection, localisées dans une matrice contiguë à la zone de photodétection (organisation à transfert de trame) ou bien localiées au niveau de chaque pixel (organisation interligne). Mais en technologie CMOS il est nécessaire d'utiliser plusieurs transistors au niveau de chaque pixel. Ces transistors, leurs liaisons, et les conducteurs de ligne et de colonne permettant leur fonctionnement, réduisent l'espace disponible pour réaliser une zone photosensible proprement dite. Il en résulte une sensibilité réduite pour une taille de pixel donnée. Ou bien, réciproquement, à sensibilité donnée, il en résulte une taille de pixel accrue donc une augmentation de la taille de la puce et des objectifs optiques associés, ce qui est coûteux, ou bien encore, il en résulte une diminution du nombre de pixels donc de la résolution du capteur si on maintient la taille de la puce.

L'invention vise à proposer une structure de pixel améliorée pour un capteur en technologie CMOS, permettant un bon compromis sur ces différents paramètres (taille de capteur, résolution, sensibilité), tout en permettant un contrôle de durée d'exposition et une exposition simultanée de tous les pixels du capteur avant lecture de l'image recueillie par l'ensemble des pixels.

Selon l'invention, on propose un capteur d'image, comportant une matrice de points photosensibles, avec, dans la zone de croisement de chaque ligne et chaque colonne de la matrice, un pixel comportant :
- une zone photosensible de type de conductivité N, apte à accumuler des charges photosensibles pendant une durée d'exposition,
- une zone de stockage de type N apte à recevoir et conserver temporairement les charges de la zone photosensible,
- une première grille de transfert commandée par une électrode pour autoriser le transfert de charges de la zone photosensible vers la zone de stockage,
- une deuxième grille de transfert pour autoriser le transfert des charges de la zone photosensible vers un conducteur d'alimentation commun à toute la matrice,
- une troisième grille de transfert pour autoriser le transfert de charges entre la zone de stockage et le conducteur d'alimentation,
- un premier transistor MOS suiveur ayant son drain relié au conducteur d'alimentation, et sa grille constituée par une quatrième grille de transfert, cette grille étant reliée à la zone de stockage de telle manière que le potentiel de la source du premier transistor MOS suive, lorsque ce transistor conduit un courant, les variations du potentiel de la zone de stockage,
- un deuxième transistor MOS pour autoriser la conduction de courant dans le premier transistor MOS, le drain du deuxième transistor étant relié à la source du premier, la source du deuxième transistor étant reliée à un conducteur de colonne commun à tous les pixels d'une même colonne, et le deuxième transistor ayant une grille constituée par une cinquième grille de transfert,
- un premier conducteur de ligne ou conducteur de sélection de ligne, relié à la la cinquième grille de transfert de tous les pixels d'une même ligne, un deuxième conducteur de ligne ou conducteur de réinitialisation, relié à la troisième grille de transfert de tous les pixels d'une même ligne, un troisième conducteur ou conducteur de transfert ou de commande d'exposition, relié à la première grille de transfert de tous les pixels de la matrice,
caractérisé en ce que la deuxième grille de transfert est reliée au premier conducteur de ligne.

La structure de chaque pixel de la matrice est donc une structure à cinq grilles de transfert et une zone photosensible, ce qui constitue un circuit relativement complexe au niveau du croisement de chaque ligne et chaque colonne, mais la configuration selon l'invention est telle que les pixels ne sont reliés aux circuits de commande périphériques que par quatre conducteurs (outre l'alimentation et la masse) qui sont : deux conducteurs de ligne (un pour la sélection, un pour la réinitialisation à chaque nouvelle acquisition), un conducteur de colonne pour la lecture de l'image acquise, et un conducteur commun à tous les pixels, pour le contrôle de la durée d'exposition. Ce nombre est particulièrement faible compte-tenu de la complexité du fonctionnement d'un capteur d'image en technologie CMOS, et les contraintes de réalisation peuvent être minimisées.

Le brevet US 6 566 697 et la publication US 2001/0015831 décrivent des pixels à cinq grilles de transfert ayant un plus grand nombre de conducteurs de commande.

Les première, deuxième et troisième grille de transferts sont de préférence des grilles de transfert surplombant des zones semiconductrices dont le dopage est tel que la tension de seuil d'autorisation de passage de charges dans ces zones soit pratiquement nulle. On rappelle qu'une grille de transfert située au dessus d'une zone semiconductrice de type P autorise le passage de courant entre deux zones de type N situées de part et d'autre de la grille, à savoir une zone de source et une zone de drain, lorsque la tension entre la grille et la zone de source dépasse un seuil déterminé VT dépendant de la distance entre la grille et le substrat et dépendant du dopage de la zone de type P ; on peut, en agissant sur cette distance et sur le dopage plus ou moins important de la zone semiconductrice surplombée, régler à volonté ce seuil et en particulier l'abaisser à une valeur proche de zéro ; une méthode consiste notamment à compenser partiellement le dopage de la zone P en rajoutant localement des impuretés de type de conductivité N dans le substrat au dessous de ces trois grilles. Une autre méthode consiste à choisir un dopage approprié du substrat qui coorespond à une tension de seuil nulle ou très proche de zéro.

De préférence, les premier et deuxième transistors MOS sont des transistors à canal N classiques, ayant une tension de seuil non nulle (par exemple de l'ordre de 0,5 volt, la tension d'alimentation Vdd étant à 2,5 volt) et ils sont formés dans un caisson de type P formé à la surface du substrat semiconducteur dans lequel est formé le capteur. Au contraire, les première, deuxième et troisième grilles de transfert surplombent directement des zones du substrat semiconducteur, dopées localement en fonction des tensions de seuil désirées, mais elles ne surplombent pas des zones formées dans un caisson.

La zone photosensible est de préférence constituée par une zone dopée de type N située au dessous d'une zone peu profonde de type P mise à la masse.

De préférence, la matrice de pixels est organisée en quinconce, c'est-à-dire que si l'on considère que les lignes de la matrice sont horizontales et les colonnes sont verticales, un registre de commande de lignes étant situé sur un bord vertical de la matrice et les circuits de recueil de charges en bout de colonne étant situés sur un bord horizontal de la matrice, alors les directions dans lesquelles les centres des zones photosensibles se trouvent les plus proches les unes des autres sont les lignes diagonales de la matrice. Les grilles de transfert et transistors constituant l'électronique de commande du pixel associée à une zone photosensible sont de préférence rassemblées dans une zone de commande située en un coin de la zone photosensible (c'est-à-dire ni au centre ni réparties sur tout le pourtour), et les directions dans lesquelles les centres des zones de commande sont les plus proches les uns des autres sont situés le long de diagonales de la matrice.

D'autres caractéristiques et avantages de l'invention apparaîtront à la lecture de la description détaillée qui suit et qui est faite en référence aux dessins annexés dans lesquels :
- la figure 1 représente le schéma électrique de l'électronique de commande d'un pixel de la matrice ;
- la figure 2 représente une coupe du substrat semiconducteur portant la matrice, la coupe étant effectuée de manière qu'on puisse y voir toutes les zones semiconductrices utiles du pixel ;
- la figure 3 représente une de dessus de principe du pixel formé sur un substrat semiconducteur ;
- la figure 4 représente une vue générale de l'organisation en quinconce des pixels de la matrice ;
- la figure 5 représente une vue simplifiée montrant la disposition des conducteurs de ligne ;
- la figure 6 représente une vue simplifiée montrant la disposition des conducteurs de colonne ;
- la figure 7 représente une vue générale d'une matrice de prise d'image en couleurs.

Le capteur d'image matriciel est formé sur un substrat semiconducteur de type de conductivité P, dans lequel sont diffusées localement des impuretés de type N ou P pour former des zones de type P et des zones de type N de dopages variables. Le symbole N+ ou P+ sera utilisé pour désigner des zones de type N ou P assez fortement dopées donc assez fortement conductrices. Le symbole P- sera utilisé pour désigner des zones de substrat de type P peu dopées. Le corps du substrat dans lequel est formé le capteur est de type P-.

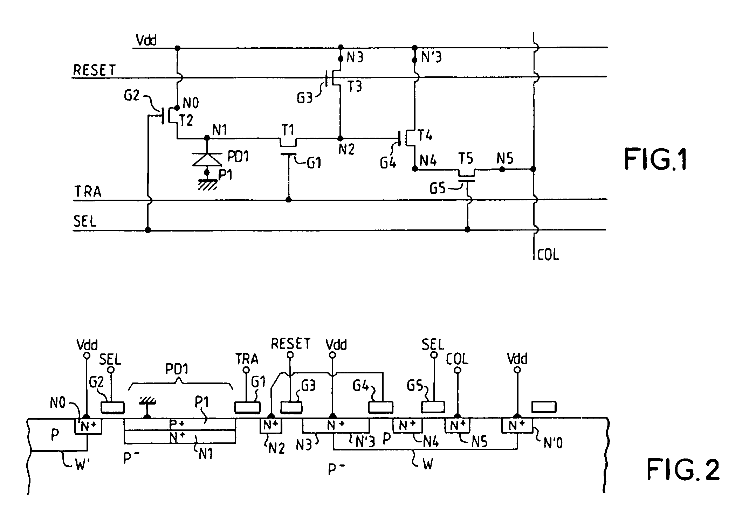

Le pixel des figures 1 et 2 comprend un élément photosensible qui dans cet exemple est une diode photosensible PD1, constituée par une jonction entre une zone P1 de type P+ et une zone N1 de type N+. De préférence, la zone P1 est formée à la surface du substrat et est mise à la masse (tension d'alimentation nulle), le substrat de type P- étant également à la masse par l'intermédiaire d'une diffusion de type P+ non représentée. La zone N1 est ici située entièrement au dessous de la zone P1. On appellera zone photosensible la zone N1 : c'est là que sont collectées les charges négatives résultant d'un éclairement du pixel, du fait que cette zone reste à un potentiel supérieur à celui de la zone P1.

Sur la figure 1 on a symbolisé par deux transistors T1 et T2 des éléments de commande adjacents à la zone photosensible N1 et permettant de transférer des charges vers cette zone photosensible ou depuis cette zone photosensible. En réalité, comme on le voit sur la figure 2, il ne s'agit pas de transistors au sens où ces transistors auraient un drain, une source et une grille autonomes, car la source de ces transistors n'est pas autonome mais elle est constituée par la zone N1 elle-même. Ces éléments de commande T1 et T2 sont donc essentiellement des moyens de transfert de charges comprenant une grille de transfert (grille G1 pour le transistor T1, grille G2 pour le transistor T2) au dessus d'un canal séparant la zone N1 des zones de drain.

La première grille de transfert G1 permet de transférer des charges de la zone photosensible N1 vers une zone de drain N2, dite zone de stockage, dopée de type N+, à la surface du substrat. Cette grille G1 autorise ce transfert après une durée d'exposition déterminée.

La deuxième grille de transfert, G2, permet de transférer des charges de la zone photosensible N1 vers une zone de drain N0 de type N+, reliée à un conducteur général d'alimentation Vdd ; ce transfert est effectué, comme on le verra plus loin, pour une réinitialisation du potentiel de la zone photosensible. Le potentiel fixe du conducteur d'alimentation Vdd peut être par exemple de 2,5 volts.

Une troisième grille de transfert G3 permet de transférer des charges depuis la zone de stockage N2 jusqu'à une zone de drain N3, de type N+, reliée au conducteur d'alimentation Vdd ; cette grille G3 sert à une réinitialisation du potentiel de la zone de stockage N2. Cette grille étant placée au dessus du substrat entre deux diffusions de type N+ constitue un transistor MOS à part entière.

Deux transistors T4 et T5, ayant chacun une source, un drain et une grille, sont constitués dans un caisson W de type P formé à la surface du substrat P- et plus dopé que le substrat. Le caisson étant plus dopé que le reste du substrat, les tensions de seuil des transistors T4 et T5 sont a priori plus élevées que les tensions de seuil de transistors formés directement dans le substrat P-. Sur la figure 2, on voit le caisson W de type P sur la droite ; le caisson W' sur la gauche de la figure, correspond à un pixel adjacent à gauche du pixel considéré.

Le transistor T4 a sa grille G4 reliée, par un conducteur en métal ou en silicium polycristallin, à la zone de stockage N2. Son drain est constitué par une zone N'3 de type N+, située dans le caisson W, et qui est reliée au conducteur d'alimentation Vdd. La zone N'3 peut être constituée par un prolongement de la zone N3 (située hors du caisson W) jusqu'à l'intérieur du caisson W. La source du transistor T4 est constituée par une zone N4 de type N+, située dans le caisson W.

Le transistor T4 est un transistor suiveur au sens où sa source suit le potentiel de sa grille (à un décalage près qui est la valeur de la tension de seuil grille-source du transistor), tout au moins lorsque la conduction de courant est autorisée dans ce transistor et on verra que ce n'est que lors de la phase de lecture de charges de la ligne de pixels que cette conduction est possible.

Pour la lecture de charges d'une ligne de pixels, le transistor T5, en série avec le transistor T4, est mis en conduction pour permettre la conduction du transistor T4. Le transistor T5 a son drain constitué par la même région N4 que la source du transistor T4 ; il a une grille de transfert G5 reliée à un conducteur de sélection de ligne SEL commun à tous les pixels d'une même ligne ; et il a sa source constituée par une région N5 de type N+ reliée à un conducteur de colonne COL commun à tous les pixels d'une même colonne.

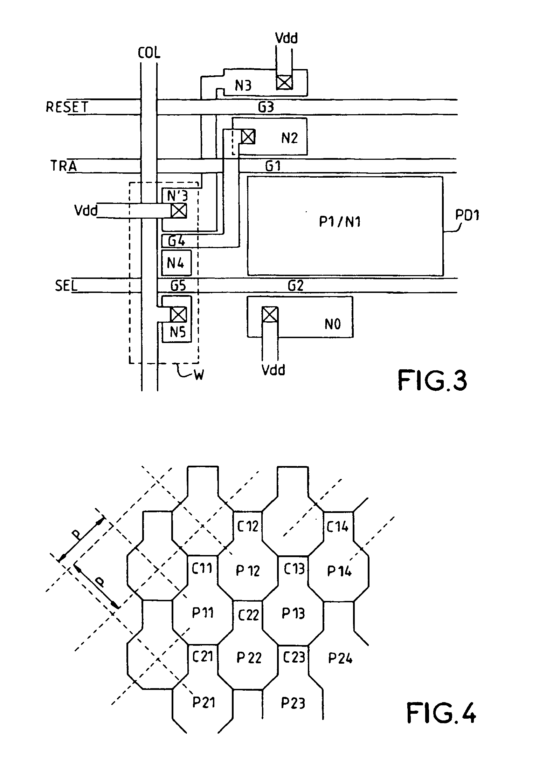

La figure 3 représente une vue de dessus de principe montrant les différentes diffusions d'impuretés de type N à la surface du substrat et les grilles de transfert qui surplombent des zones de type P ou P- séparant deux régions de type N+. Les dimensions et dispositions géographiques des zones ne sont données qu'à titre d'exemple, et dans une réalisation concrète on cherchera à minimiser l'encombrement de l'ensemble des grilles de transfert et de leurs connexions pour laisser libre une surface aussi grande que possible, non recouvertes de grilles ou connexions, au dessus de la photodiode PD1.

Comme on l'a dit, la photodiode PD1 est constituée par une région P1 de type P+ mise à la masse et recouvrant une région N1 de type N+.

Les grilles de transfert G1 à G5 seront en silicium polycristallin conformément à la technologie MOS généralement en usage. Ce silicium polycristallin peut être relié à des conducteurs métalliques ou être doublé par des conducteurs métalliques, ou encore être relié à des zones semiconductrices diffusées de type N+ selon les cas. Par exemple, pour relier toutes les grilles G2 des pixels d'une ligne à un même conducteur de ligne SEL, on pourra
- soit prévoir que le conducteur de ligne est, sur toute sa longueur, en silicium polycristallin,
- soit prévoir que le conducteur de ligne est, sur toute sa longueur, en silicium polycristallin doublé par un métal plus conducteur (aluminium, tantale, etc.) avec lequel il est régulièrement en contact,
- soit prévoir que le conducteur de ligne est une ligne métallique (aluminium ou deuxième niveau de silicium polycristallin) venant contacter une grille G2 en silicium polycristallin de premier niveau constituée seulement localement dans le pixel entre la photodiode PD1 et la zone N0.

Les conducteurs de colonne peuvent être constitués par un métal (aluminium) ; le conducteur d'alimentation peut être constitué par un niveau de métal supérieur.

Sur la figure 3 qui est une figure de principe, on a considéré pour simplifier que le conducteur SEL était sur toute sa longueur une ligne de silicium polycristallin.

Le même commentaire sur la réalisation des grilles peut être fait pour les grilles G5 (reliée au même conducteur de sélection de ligne SEL) et pour les grilles G3 reliées au conducteur RESET reliant toutes les grilles G3 d'une même ligne ; le même commentaire peut être fait aussi pour les grilles G1, avec la différence que la grille G1 est reliée à un conducteur commun à toute la matrice et pas seulement à la ligne de pixels comme c'est le cas pour les grilles G2, G5, et G3.

Les zones N5 de tous les pixels d'une même colonne sont reliées à un même conducteur de colonne COL. Ce conducteur est représenté comme étant placé à côté de la zone N5, mais le conducteur peut très bien passer au dessus de la zone N5 et venir en contact localement avec cette zone.

La zone N2 est localement reliée, à l'intérieur du pixel, à la grille G4 du même pixel mais elle n'est pas reliée aux pixels voisins. La liaison peut être faite par un conducteur métallique qui relie la zone N2 et la grille G4. Cependant, puisque la grille G4 est en silicium polycristallin, la liaison peut être faite par un prolongement du silicium polycristallin allant jusqu'à la zone N2 et en contact ohmique direct avec cette zone.

Les zones N0, N3, N'3 sont reliées à des conducteurs métalliques portés à Vdd et distribués sur toute la matrice. Ces conducteurs peuvent descendre de place en place sur le silicium des régions N0, N3, N'3 et établir un contact ohmique localement avec ces régions.

Sur la figure 3, les conducteurs de ligne SEL, RESET, et le conducteur commun TRA sont représentés rectilignes, de même que le conducteur de colonne COL, mais ils ne sont pas nécessairement rectilignes comme on le verra à propos des figures 4 et suivantes.

Le pixel qui vient d'être décrit, au croisement d'une ligne de pixels et d'une colonne de pixels du réseau matriciel, ne comporte que les conducteurs de commande suivants, outre une alimentation générale et une masse : un conducteur de colonne, deux conducteurs de ligne SEL et RESET, et un conducteur général TRA qui contrôle la fin d'exposition ; le début d'exposition est assuré par une impulsion appliquée simultanément sur toutes les grilles G2. Ce nombre de conducteurs est relativement modéré, bien qu'il permette une maîtrise du temps d'exposition pour tous les pixels à la fois de la matrice, contrairement à des systèmes dans lesquels les pixels seraient exposés successivement ligne par ligne.

La matrice fonctionne de la manière suivante pour une prise d'image et une lecture de cette image :
a. état initial :
   au départ, avant le temps t0 correspondant au début d'une nouvelle prise de vue, tous les conducteurs de ligne RESET, qui ont un rôle de commande de réinitialisation, ont été mis au potentiel Vdd ; les canaux sous les grilles de transfert G3 sont ouverts pour tous les pixels de la matrice ; il en résulte que toutes les zones de stockage N2 sont au potentiel Vdd ; les conducteurs de sélection de ligne SEL sont à la masse et les canaux sous les grilles G2 sont fermés ; le conducteur de transfert TRA est au potentiel de masse ;
b. déclenchement de l'exposition :
   au temps t0, une impulsion de déclenchement de nouvelle prise de vue, est appliquée par les conducteurs SEL à toutes les grilles G2 de la matrice ; l'impulsion est une impulsion brève au niveau de potentiel Vdd, d'un instant t0 à un instant t'0 ; le canal sous la grille G2 s'ouvre et vide toutes les charges de la zone photosensible N1 pour tous les pixels de la matrice ; l'impulsion est brève devant la durée d'exposition : elle dure par exemple une microseconde, la durée étant cependant suffisante pour que la zone N1 se vide de toutes charges et passe au potentiel de référence de la photodiode complètement déplétée ; après disparition de cette impulsion par retour au potentiel 0 des grilles G2, les canaux sous les grilles de transfert G2 sont refermés ; les canaux sous les grilles G2 sont également fermés ; les zones photosensibles N1 sont dès lors vides d'électrons ; les conducteurs de réinitialisation de ligne RESET sont, immédiatement après la fin de l'impulsion sur le conducteur TRA, ramenés au potentiel de la masse, refermant les canaux sous les grilles G3 pour toute la matrice ; les zones de stockage N2 sont dès lors isolées et chargées au potentiel Vdd ;
c. exposition :
   à partir de l'instant t'0, les zones photosensibles recueillent et stockent, pour tous les pixels de l'image, les charges photogénérées par l'exposition à la lumière ; le potentiel de la zone photosensible baisse en proportion de l'éclairement reçu sur le pixel pendant la durée d'exposition choisie ;
d. fin d'exposition :
   la durée d'exposition commencée à t'0 se termine à un instant t1 auquel une nouvelle impulsion brève, qui est maintenant une impulsion de fin de durée d'exposition, est appliquée à toute la matrice simultanément par le conducteur TRA ; l'impulsion est au potentiel Vdd, pendant une durée brève (par exemple une microseconde) mais suffisante pour vider les charges de la zone photosensible dans la zone de stockage ; la durée d'exposition est donc unique pour toute la matrice et contrôlée par un circuit périphérique du capteur qui contrôle le conducteur TRA ; l'ouverture du canal sous la grille de transfert fait passer les charges accumulées dans la zone photosensible vers la zone de stockage N2 qui avait été préalablement vidée de ses charges puis isolée ; le canal sous G1 est refermé à un instant t'1 très proche de t1 ; le potentiel du point N2 chute d'une valeur qui est proportionnelle aux charges intégrées dans la zone photosensible et déversées dans la zone N2 ; cette chute de potentiel dépend de la capacité (pratiquement fixe) de la zone N2 ; elle représente l'éclairement pendant la durée d'exposition.
e. avant lecture de la matrice :
   la zone de stockage N2 est isolée (canal sous G1 et G3 fermé, grille G4 isolée) ; son potentiel va rester constant pendant toute la phase de lecture de l'image qui vient ainsi d'être enregistrée dans les zones N2 ; la lecture va se faire ligne par ligne pour reporter sur le conducteur de colonne COL d'abord le potentiel de la zone N2 correspondant au pixel au croisement de cette colonne et de la première ligne, puis le potentiel de la zone N2 correspondant au pixel de la deuxième ligne, etc. ; la sélection d'une ligne se fait en portant le conducteur de ligne SEL à Vdd pendant le temps nécessaire à la lecture de cette ligne ;
f. lecture d'une ligne (phase 1) :
   - lorsqu'on vient lire la ligne considérée, le conducteur SEL de cette ligne est mis à Vdd et le transistor T5 devient conducteur ; la mise en conduction du transistor T5 autorise la conduction de courant dans le transistor T4, alors qu'aucun courant ne pouvait passer auparavant, et le transistor T4 peut alors se comporter en suiveur de tension et reporter sa tension de grille sur sa source, au décalage VT près correspondant au seuil de conduction du transistor T4 ; la valeur du potentiel de la zone N2, diminuée de la tension de seuil VT est donc reportée sur le conducteur de colonne COL, à travers les transistors T4 et T5 ; le potentiel du conducteur de colonne est mémorisé, par exemple par un dispositif échantillonneur-bloqueur en bout de colonne, en attente d'une nouvelle mesure de potentiel effectuée immédiatement après et destinée à éliminer, par soustraction, l'influence de la tension de seuil sur la mesure ;
   - en même temps, le conducteur de sélection de ligne SEL rend conducteur le canal sous la grille G2 mais l'élimination des photocharges qui en résulte est sans importance puisque ces charges ne contiennent plus d'information utile ;
g. lecture d'une ligne (phase 2) :
   avant de ramener à une valeur basse le potentiel du conducteur de sélection de ligne SEL, on active le conducteur de ligne RESET de la même ligne de pixels, la zone N2 passe au potentiel Vdd ; le potentiel de colonne prend la valeur Vdd diminuée de la tension de seuil VT ; puis on remet ce conducteur à la masse ; le potentiel de la colonne est alors stocké par un deuxième échantillonneur bloqueur ; en soustrayant cette mesure de la mesure effectuée à l'étape f, on élimine l'inconnue VT qui peut varier d'un pixel à l'autre, et on obtient une évaluation précise du potentiel de la zone N2, représentant l'éclairement du pixel ;
h. lecture des autres lignes :
   on ramène à zéro le potentiel du conducteur de sélection de ligne SEL, isolant la colonne COL de ce pixel, et on passe à la lecture d'une autre ligne ;
i. réinitialisation si nécessaire après lecture de toute l'image :
   lorsque toutes les lignes ont fait l'objet de cette double mesure, on peut faire une nouvelle prise d'image mais cette nouvelle prise d'image suppose (étape a) que toutes les zones de stockage N2 soient à l'état haut (Vdd) ; il faut terminer la procédure après la lecture de toutes les lignes par une dernière étape i qui consiste à faire passer, simultanément ou en séquence accélérée, à Vdd tous les conducteurs RESET.

L'étape de transfert de charges depuis la zone photosensible vers la zone de stockage doit permettre un vidage total de charges, sans charge résiduelle qui resterait stockée dans la zone N1 par suite de l'existence d'une barrière de potentiel entre une grille de transfert et la source de charges qu'on veut transférer. De même, l'application de tension Vdd à la zone de stockage N2 doit permettre que cette tension Vdd et non pas la tension Vdd diminuée d'une tension de seuil soit appliquée à la zone N2.

C'est pourquoi on choisit de préférence que les tensions de seuil des grilles G1, G2, et G3, mais pas nécessairement celles des grilles G4 et G5, soient aussi proches que possible de zéro. Pour cela, d'une part les grilles G1, G2, G3 sont formées au dessus du substrat P- peu dopé, et d'autre part, en fonction des paramètres de la technologie (épaisseurs d'isolant de grille, valeur du dopage P-), on peut prévoir de compenser légèrement, par une impureté de type N (phosphore ou arsenic notamment), le dopage de type P- jusqu'à ce que la tension de seuil soit très proche de zéro volt.

On va maintenant décrire l'organisation préférentielle de la matrice de pixels, compte-tenu des éléments qui sont nécessaires à la commande du pixel et compte-tenu du fait qu'on souhaite optimiser les caractéristiques de sensibilité, résolution, et rapidité de lecture d'une image (pour pouvoir prendre plusieurs images successives à cadence élevée).

La figure 4 représente l'agencement général des pixels de la matrice. Cet agencement est en quinconce, c'est-à-dire que si on prend une ligne globalement horizontale de pixels, un pixel sur deux est décalé vers le haut ou vers le bas par rapport aux pixels qui l'encadrent et qui font partie de la même ligne. Un pixel désigné par Pij est le pixel correspondant à l'intersection de la ligne de rang i et de la colonne de rang j. Les pixels P11, P12, P13, P14 font partie de la même ligne de rang 1.

Dans cette disposition, en supposant que chaque pixel occupe globalement une surface à peu près carrée de p micromètres sur p micromètres, symbolisée par le quadrillage oblique de la figure 4, le pas des lignes horizontales (séparation dans le sens vertical entre deux pixels voisins P12 et P22 appartenant à une même colonne et à deux lignes différentes) est p.(2)^{1/2} et le pas en colonnes verticale (séparation entre deux pixels voisins P11 et P12 appartenant à une même ligne et deux colonnes différentes est p/(2)^{1/2}. En diagonale, le pas entre les pixels adjacents est p. Les directions dans lesquelles les centres des zones photosensibles sont les plus proches les uns des autres sont en effet les diagonales et la distance entre ces centres est p.

Pour maximiser la sensibilité en laissant libre une zone photosensible aussi grande que possible, non masquée par les éléments de commande (grilles de transfert G1 à G5, connexions métalliques, zones diffusées autres que la zone photosensible), on donne au pixel selon l'invention une forme générale octogonale, avec une extension locale qui dans l'exemple de la figure 4 est concentrée contre un côté de l'octogone, par exemple au haut de l'octogone. L'extension, à peu près carrée, désignée par Cij, correspond au pixel Pij et regroupe les éléments de commande de ce pixel. Les lignes délimitant le pourtour de l'octogone sont utilisées pour le passage de conducteurs en ligne ou en colonne comme on l'explique plus loin.

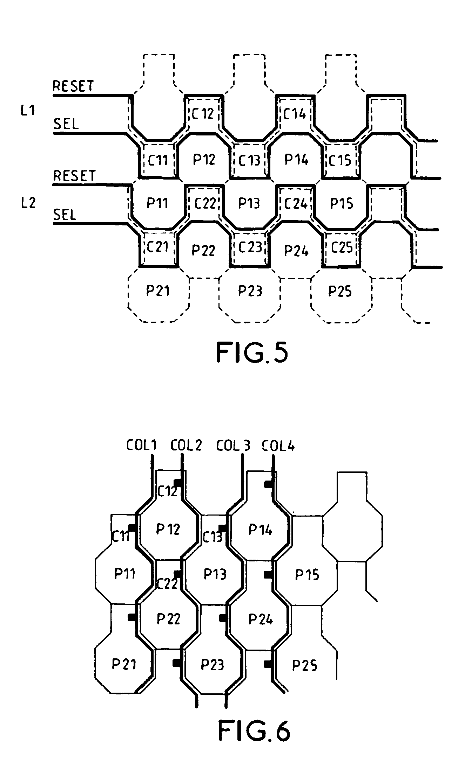

La figure 5 représente de manière simplifiée le passage des conducteurs de ligne connectés aux circuits de commande des pixels dans cette configuration en quinconce. Une ligne L1 de pixels en quinconce, par exemple P11, P12, P13, P14, P15 comprend pour la commande des pixels correspondants les deux conducteurs de ligne SEL et RESET, et ces deux conducteurs suivent globalement une ligne générale brisée conformément à la disposition en quinconce. Plus précisément, l'un des conducteurs, par exemple le conducteur SEL, passe le long du haut de chaque surface carrée C11, C12, C13, C14, C15 comportant les circuits de commande des pixels, en suivant également un côté oblique de la surface octogonale du pixel, alors que l'autre conducteur passe plutôt par le bas de chaque surface carrée comportant les circuits de commande.

La figure 6, qui pourrait être superposée à la figure 5 mais qui est représentée séparément pour rendre la disposition plus intelligible, représente les conducteurs de colonne COL1, COL2, COL3, COL4 associés à chaque colonne de pixel. Le conducteur de colonne COL1 associé à la colonne de rang 1 passe le long des pixels P11 et P21 en suivant les bords verticaux et obliques d'un côté (à droite) de la surface octogonale et des surfaces carrées C11, C12 qui comprennent des éléments (le transistor T5, figure 1 à 3) auxquels ce conducteur de colonne est électriquement relié. Le conducteur de colonne COL2 de rang 2 passe de la même manière à droite des pixels P12, P22 en suivant leurs bords obliques et verticaux et il est relié aux transistors T5 contenus dans les surfaces C12, C22 associées à ces pixels.

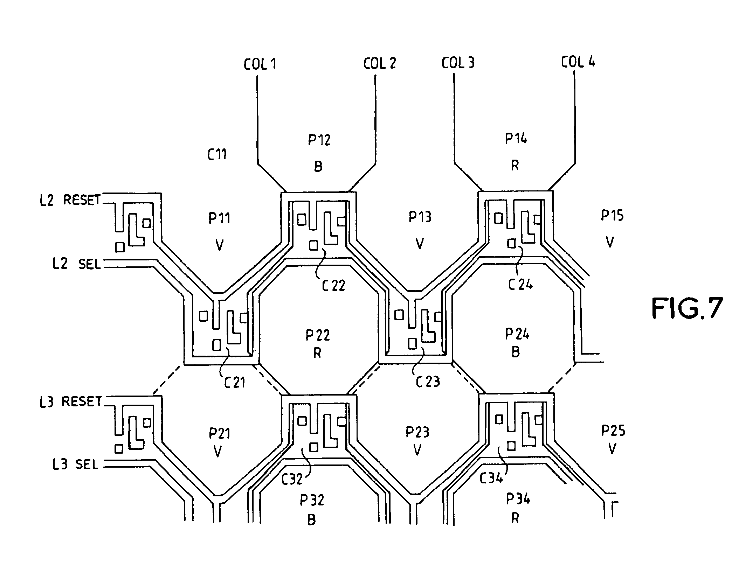

Sur la figure 7, on a représenté l'ensemble de l'organisation de pixels en quinconce, en précisant en outre l'organisation des couleurs pour une matrice en couleurs. La lettre R, V, B associée à chaque pixel indique que le pixel correspondant est surmonté d'un filtre de couleur rouge, verte ou bleue respectivement. La disposition géométrique en quinconce est particulièrement favorable pour un calcul d'interpolation permettant, connaissant les niveaux de luminance des couleurs primaires détectés en chaque pixel selon le filtre qui recouvre ce pixel, de reconstituer une couleur composée pour chacun de ces pixels. Ainsi, le pixel rouge P22 peut être considéré comme un point éclairé par une composition de couleur correspondant au niveau de rouge reçu en ce point P22, à un niveau de vert qui est la demi-somme des niveaux de luminance verte reçus sur les pixels P11 et P23 qui sont symétriques par rapport au pixel P22 ou le quart de la somme des niveaux de luminance reçues sur les quatre pixels symétriques P11, P23, P13 et P21, et à un niveau de bleu qui est la demi-somme des couleurs bleues reçues sur les pixels P12 et P32 qui sont symétriques par rapport au pixel P22. De même, un pixel vert P23 peut être considéré, par interpolation comme étant éclairé par une composition de couleur correspondant au niveau de vert qu'il reçoit, au niveau de rouge correspondant à la demi-somme des niveaux de luminance reçus sur les pixels rouges P22 et P34 qui l'encadrent symétriquement, et au niveau de bleu correspondant à la demi-somme des niveaux de luminance reçus par les pixels bleus P24 et P32 qui l'encadrent symétriquement. Cette interpolation fournit des points colorés avec des transitions particulièrement bien lissées réduisant les phénomènes de moirés colorés en cas de fortes variations de couleur dans l'image.

Par rapport à des organisations antérieures connues, l'organisation de cette matrice permet
- une augmentation de sensibilité du capteur à résolution donnée et surface donnée de la matrice,
- une augmentation de résolution à sensibilité donnée (c'est-à-dire à surface donnée de pixel),
- une lecture plus rapide de la matrice à résolution donnée et sensibilité donnée, donc un délai plus court avant une nouvelle prise de vue.

## Revendications

1. Capteur d'image comportant une matrice de points photosensibles, avec, dans la zone de croisement de chaque ligne et chaque colonne de la matrice, un pixel comportant :
- une zone photosensible (N1) de type de conductivité N, apte à accumuler des charges photosensibles pendant une durée d'exposition,
- une zone de stockage (N2) de type N apte à recevoir et conserver temporairement les charges de la zone photosensible,
- une première grille de transfert (G1) pour autoriser le transfert de charges de la zone photosensible (N1) vers la zone de stockage (N2),
- une deuxième grille de transfert (G2) pour autoriser le transfert des charges de la zone photosensible (N1) vers un conducteur d'alimentation (Vdd) commun à toute la matrice,
- une troisième grille de transfert (G3) pour autoriser le transfert de charges entre la zone de stockage (N2) et le conducteur d'alimentation (Vdd),
- un premier transistor MOS suiveur (T4) ayant son drain relié au conducteur d'alimentation, et sa grille constituée par une quatrième grille de transfert (G4), cette grille étant reliée à la zone de stockage (N2) de telle manière que le potentiel de la source du premier transistor MOS suive, lorsque ce transistor conduit un courant, les variations du potentiel de la zone de stockage,
- un deuxième transistor MOS (T5) pour autoriser la conduction de courant dans le premier transistor MOS (T4), le drain du deuxième transistor étant relié à la source du premier, la source du deuxième transistor étant reliée à un conducteur de colonne (COL) commun à tous les pixels d'une même colonne, et le deuxième transistor ayant une grille constituée par une cinquième grille de transfert (G5),
- un premier conducteur de ligne (SEL), relié à la cinquième grille de transfert de tous les pixels d'une même ligne, un deuxième conducteur de ligne (RESET), relié à la troisième grille de transfert de tous les pixels d'une même ligne, un troisième conducteur (TRA), relié à la première grille de transfert de tous les pixels de la matrice,
**caractérisé en ce que** la deuxième grille de transfert est reliée au premier conducteur de ligne (SEL).

2. Capteur d'image selon la revendication 1, **caractérisé en ce que** la tension de seuil de mise en conduction du canal constitué sous la première grille de transfert (G1) est voisine de zéro.

3. Capteur d'image selon l'une des revendications 1 et 2, **caractérisé en ce que** la tension de seuil de mise en conduction du canal constitué sous la deuxième grille de transfert (G2) est voisine de zéro.

4. Capteur d'image selon l'une des revendications 1 à 3, **caractérisé en ce que** la tension de seuil de mise en conduction du canal constitué sous la troisième grille de transfert (G3) est voisine de zéro.

5. Capteur d'image selon l'une des revendications 1 à 4, **caractérisé en ce que** la tension de seuil de mise en conduction des transistors T4 et T5 est supérieure à la tension de seuil de mise en conduction du canal sous les grilles G1, G2 et G3.

6. Capteur d'image selon l'une des revendications 1 à 5, **caractérisé en ce que** la zone photosensible est une zone dopée de type N formée dans le substrat semiconducteur dans lequel sont formés les pixels, cette zone étant située sous une zone de type P mise à la masse.

7. Capteur d'image selon l'une des revendications 1 à 6, **caractérisé en ce** la matrice de pixels est organisée en quinconce, les directions dans lesquelles les centres des zones photosensibles des différents pixels se trouvent les plus proches les unes des autres étant les lignes diagonales de la matrice.

## Claims

1. Image sensor comprising a matrix of photosensitive elements, with, in the region where each row and each column of the matrix cross, a pixel having:
- a photosensitive region (N1) of n-type conductivity, capable of storing photosensitive charges for an exposure time;
- an n-type storage region (N2) capable of receiving and temporarily storing the charges from the photosensitive region;
- a first transfer gate (G1) for authorizing the transfer of charges from the photosensitive region (N1) to the storage region (N2);
- a second transfer gate (G2) for authorizing the transfer of charges from the photosensitive region (N1) to a supply conductor (Vdd) common to the entire matrix;
- a third transfer gate (G3) for authorizing the transfer of charges between the storage region (N2) and the supply conductor (Vdd);
- a first follower MOS transistor (T4) having its drain connected to the supply conductor, and its gate formed by a fourth transfer gate (G4), this gate being connected to the storage region (N2) in such a way that the potential of the source for the first MOS transistor, when this transistor is conducting a current, follows the variations in the potential of the storage region;
- a second MOS transistor (T5) for authorizing the current conduction in the first MOS transistor (T4), the drain of the second transistor being connected to the source of the first, the source of the second transistor being connected to a column conductor (COL) common to all the pixels of any one column, and the second transistor having a gate formed by a fifth transfer gate (G5),
- a first row conductor (SEL) connected to the fifth transfer gate of all of the pixels of any one row, a second row conductor (RESET) connected to the third transfer gate of all the pixels of any one row, and a third conductor (TRA) connected to the first transfer gate of all the pixels of the matrix,
**characterized in that** the second transfer gate is connected to the first row conductor (SEL).

2. Image sensor according to Claim 1, **characterized in that** the threshold voltage for initiating conduction in the channel formed beneath the first transfer gate (G1) is close to zero.

3. Image sensor according to either of Claims 1 and 2, **characterized in that** the threshold voltage for initiating conduction in the channel formed beneath the second transfer gate (G2) is close to zero.

4. Image sensor according to one of Claims 1 to 3, **characterized in that** the threshold voltage for initiating conduction in the channel formed beneath the third transfer gate (G3) is close to zero.

5. Image sensor according to one of Claims 1 to 4, **characterized in that** the threshold voltage for turning on the transistors T4 and T5 is above the threshold voltage for initiating conduction in the channel beneath the gates G1, G2 and G3.

6. Image sensor according to one of Claims 1 to 5, **characterized in that** the photosensitive region is an n-doped region formed in the semiconductor substrate in which the pixels are formed, this region being located beneath a grounded p-type region.

7. Image sensor according to one of Claims 1 to 6, **characterized in that** the matrix of pixels is organized in a staggered fashion, the directions along which the centers of the photosensitive regions of the various pixels lie closest together being the diagonal lines of the matrix.

## Patentansprüche

1. Bildsensor, der eine Matrix von lichtempfindlichen Punkten aufweist, mit einem Pixel in der Kreuzungszone jeder Zeile und jeder Spalte der Matrix, das aufweist:
- eine lichtempfindliche Zone (N1) vom N-Leitfähigkeitstyp, die während einer Belichtungsdauer lichtempfindliche Ladungen akkumulieren kann,
- eine Speicherzone (N2) vom Typ N, die die Ladungen der lichtempfindlichen Zone empfangen und vorübergehend lagern kann,
- ein erstes Übertragungs-Gate (G1), um die Übertragung von Ladungen von der lichtempfindlichen Zone (N1) zur Speicherzone (N2) zu erlauben,
- ein zweites Übertragungs-Gate (G2), um die Übertragung der Ladungen von der lichtempfindlichen Zone (N1) zu einem der ganzen Matrix gemeinsamen Versorgungsleiter (Vdd) zu erlauben,
- ein drittes Übertragungs-Gate (G3), um die Übertragung von Ladungen zwischen der Speicherzone (N2) und dem Versorgungsleiter (Vdd) zu erlauben,
- einen ersten MOS-Folgetransistor (T4), dessen Drain mit dem Versorgungsleiter verbunden ist und dessen Gate aus einem vierten Übertragungs-Gate (G4) besteht, wobei dieses Gate mit der Speicherzone (N2) derart verbunden ist, dass das Potential der Source des ersten MOS-Transistors den Veränderungen des Potentials der Speicherzone folgt, wenn dieser Transistor stromleitend ist,
- einen zweiten MOS-Transistor (T5), um die Stromleitung im ersten MOS-Transistor (T4) zu erlauben, wobei der Drain des zweiten Transistors mit der Source des ersten verbunden ist, die Source des zweiten Transistors mit einem allen Pixeln einer gleichen Spalte gemeinsamen Spaltenleiter (COL) verbunden ist, und der zweite Transistor ein Gate hat, das aus einem fünften Übertragungs-Gate (G5) besteht,
- einen ersten Zeilenleiter (SEL), der mit dem fünften Übertragungs-Gate aller Pixel einer gleichen Zeile verbunden ist, einen zweiten Zeilenleiter (RESET), der mit dem dritten Übertragungs-Gate aller Pixel der gleichen Zeile verbunden ist, einen dritten Leiter (TRA), der mit dem ersten Übertragungs-Gate aller Pixel der Matrix verbunden ist,
**dadurch gekennzeichnet, dass** das zweite Übertragungs-Gate mit dem ersten Zeilenleiter (SEL) verbunden ist.

2. Bildsensor nach Anspruch 1, **dadurch gekennzeichnet, dass** die Schwellenspannung der Leitendmachung des unter dem ersten Übertragungs-Gate (G1) gebildeten Kanals nahe Null ist.

3. Bildsensor nach einem der Ansprüche 1 und 2, **dadurch gekennzeichnet, dass** die Schwellenspannung der Leitendmachung des unter dem zweiten Übertragungs-Gate (G2) gebildeten Kanals nahe Null ist.

4. Bildsensor nach einem der Ansprüche 1 bis 3, **dadurch gekennzeichnet, dass** die Schwellenspannung der Leitendmachung des unter dem dritten Übertragungs-Gate (G3) gebildeten Kanals nahe Null ist.

5. Bildsensor nach einem der Ansprüche 1 bis 4, **dadurch gekennzeichnet, dass** die Schwellenspannung der Leitendmachung der Transistoren T4 und T5 höher ist als die Schwellenspannung der Leitendmachung des Kanals unter den Gates G1, G2 und G3.

6. Bildsensor nach einem der Ansprüche 1 bis 5, **dadurch gekennzeichnet, dass** die lichtempfindliche Zone eine dotierte Zone vom N-Typ ist, die in dem Halbleitersubstrat geformt ist, in dem die Pixel geformt sind, wobei diese Zone sich unter einer an Masse gelegten Zone vom P-Typ befindet.

7. Bildsensor nach einem der Ansprüche 1 bis 6, **dadurch gekennzeichnet, dass** die Pixelmatrix auf Lücke gestaltet ist, wobei die Richtungen, in denen die Zentren der lichtempfindlichen Zonen der verschiedenen Pixel einander am nächsten sind, die diagonalen Linien der Matrix sind.
